# EUROPEAN PATENT APPLICATION

(11) **EP 2 014 610 A1**
(43) Date of publication of application: **14.01.2009**
(21) Application number: 07110326.1
(22) Date of filing: 15.06.2007
(51) Int. Cl.: B81B 3/00

(54) **Actuator for manipulating a fluid, comprising an electro-active polymer or an electro-active polymer composition**

(71) Applicant: Nederlandse Organisatie voor Toegepast- Natuurwetenschappelijk Onderzoek TNO, 2628 VK The Hague (NL)
(72) Inventor: Boersma, Arjen, 5237 KL s'Hertogenbosch (NL); de Zwart, Renatus Marius, 5655 JP Eindhoven (NL)
(74) Representative: van Loon, C.J.J.

(57) **Abstract**

The invention relates to a microfluidic device comprising an actuator for converting between mechanical and electrical energy comprising an electro-active polymer or electro-active polymer composition, wherein the stiffness of the actuator at or near a first surface or part thereof differs from the stiffness at or near a second surface or part thereof, or wherein the stiffness of the actuator at or near a first extremity differs from the stiffness at or near a second extremity.

Preferably the polymer comprises (alkyl)acrylate units based on a monomer represented by formula I and/or formula II

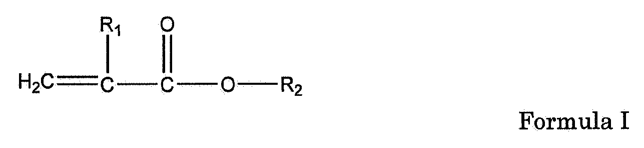

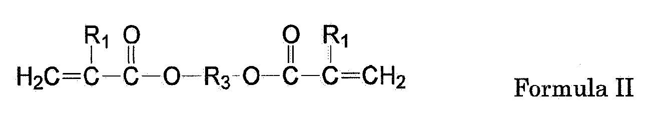

## Description

The invention relates to a microfluidic device comprising an actuator for converting between mechanical and electrical energy, to an acuator, to a method of manufacturing an actuator, and the use of an actuator.

Microfluidic devices are microstructured devices capable of holding and/or manipulating a fluid. Such devices typically comprise a pattern (structure) of one or more recesses of which at least one dimension is of a micrometer scale (typically about 1 to 1000 µm). The one or more recesses usually have a depth and/or width of in the range of 1-1000 µm. In particular the depth and/or width may be 200 µm or less, more in particular 50 µm or less. The length of the reces(es) may be in the range of 1-1000 µm or higher. The upper limit is determined by the size of the device. One or more recesses having other dimensions may be present (in addition).

The recess may be suitable for holding and/or transporting a fluid (which may be liquid, vaporous, gaseous or a combination thereof). Such recess may for instance be a channel or a chamber (which may serve as a reservoir or a buffer for a fluid). Such structures may *inter alia* be used in a biological, chemical or physical analytical technique, such as chromatography, electrophoresis, UV-VIS spectrometry, IR spectrometry, in a chemical assay or in a microbiological assay. For instance, a microstructured device may comprise a biochemical sensor, e.g. for use in a medical application or in food technology. Such device may for instance be suitable to determine the concentration and/or identity of a specific component, for example in a body fluid such as blood, plasma, serum, urine of lymph fluid.

A micro-fluidic network comprising one or more channels, chambers (buffers) and the like may in particular be present in or on a device suitable for use as a sensor. Through such recess(es) one or more reagents, samples and/or other fluids may flow. The structure may comprise one or more micro pump systems, to facilitate flowing of the fluids and/or micro-valves to manipulate a flow direction.

Examples of micro-fluidic devices are e.g. described in WO 1994/29400, WO 2004/043849, WO 2004/112961, European patent application no. 6075107.0, European patent application no. 6076307.5 or European patent application no. 6077073.2. However, it is not described how to provide such devices with internal means to manipulate a fluid in the recesses.

Fluidic streams can be manipulated in various ways. For instance, one may use pneumatic valves and pumps. However such valves and pumps tend to be bulky, and therefore not practically suitable for use in microfluidic devices.

Piezo-elements can be miniaturised and are capable of providing a high force. However, the maximum deformation of piezo-elements is low, generally below 1 %.

Recently, the use of electro-active polymers for controlling fluids has been reported. For instance, WO 2005/027161 describes an actuator comprising an electro-active polymer, which may be used in, e.g., a loudspeaker, a binary robotic device or a pump to advance fluid. The polymer is an elastomeric dielectric film disposed between at least two electrodes. Further a frame is attached to the film, which frame has a flexible element and provides a linear actuation force characteristic over displacement range. It is apparent that the frame is required to deflect the film from a first position to a second position and/or back. It is not mentioned to provide a microfluidic device with an actuator comprising an electro-active polymer for manipulating a fluid. Further, no actuator is described having a difference in stiffness between opposing surfaces or opposing extremities of the film.

US 20031214199 relates to a device for controlling fluid flow wherein an electro-active polymer is arranged to deflect from a first position to a second position in response to a change in electric field. The polymer may be a portion of a surface of a structure that is immersed in an external fluid flow, such as the surface of an airplane wing, or be a portion of a surface of a structure used in an internal flow, such as a bounding surface of a fluid conduit. It is noted that US 2003/214199 mentions that in an embodiment pre-strain may be provided unequally in different directions for a portion of a polymer to provide an anisotropic pre-strained polymer such that the polymer may deflect greater in one direction than another when actuated. It is speculated that stiffness in the pre-strain direction is increased. However, it is apparent that pre-straining does not lead to a gradient in stiffness between opposing surfaces or opposing extremities of a material.

In particular for use in a micro-fluidic device, it is desired to provide an actuator that is thin enough to be positioned in a recess of the device and/or that is simple to manufacture. An actuator having a complex structure, such as an actuator comprising a frame to deflect and/or be restored, or an actuator having a tubular geometry may be difficult to incorporate into a fluid handling system, in particular such a system having a low thickness, or at least having a recess wherein at least one dimension is small (in particular 1000 µm or less).

It would be desirable to provide an alternative for existing actuators, in particular an actuator which may be used as a fluid manipulator, which preferably is easy to manufacture, has a simple design (such as essentially consisting of a layered structure, without needing additional springs, frames or the like to impart deformation), and/or which may be easy to incorporate in or attach to a device for handling a fluid, in particular a micro-fluidic device.

Accordingly, it is an object to provide a simple method for providing an actuator, in particular a method which is suitable to provide a (thin) film actuator.

Further, it is an object of the present invention to provide a novel actuator, in particular an actuator for use as a fluid manipulator, more in particular such an actuator in a micro-fluidic device.

Further, it is an object of the invention to provide a novel microfluidic device, in particular a microfluidic device having a low thickness or at least a recess with at least one micro-meter scale dimension.

One or more other objects which may be realised in accordance with the invention will be apparent from the remainder of the description and/or the claims.

The inventors have realised that it is possible to provide a microfluidic device with an actuator having a specific stiffness characteristic, which is in particular suitable for manipulating a fluid.

Accordingly, the present invention relates to a microfluidic device comprising an actuator for converting between mechanical and electrical energy, comprising at least a first and a second electrode and an electro-active layer, the layer comprising an electro-active polymer or electro-active polymer composition positioned between the two electrodes and arranged to deflect from a first position to a second position in response to a change in electric field, wherein the stiffness of the actuator at or near a first surface or part thereof differs from the stiffness at or near a second surface or part thereof, essentially opposite to the first surface, or wherein the stiffness of the actuator at or near a first extremity differs from the stiffness at or near a second extremity, essentially opposite from the first extremity.

The micro-fluidic device, may in particular be or comprise a micro-fluidic handling system, such as for in a chemical or biological sensor, or a valve for controlling the flow of a fluid.

The invention further relates to an actuator for converting between mechanical and electrical energy, comprising at least a first and a second electrode and an electro-active layer, the layer comprising an electro-active polymer or electro-active polymer composition positioned between the two electrodes and arranged to deflect from a first position to a second position in response to a change in electric field, wherein the stiffness of the actuator at or near a first surface or part thereof differs from the stiffness at or near a second surface or part thereof, essentially opposite to the first surface, or wherein the stiffness of the actuator at or near a first extremity differs from the stiffness at or near a second extremity, essentially opposite from the first extremity.

The invention further relates to a membrane pump, comprising a deformable membrane for displacing a fluid, wherein the membrane is an actuator according to the invention.
Figure 1 shows a 3D image of a microfluidic device provided with actuators for controlling fluid flow.
Figure 2A schematically shows the construction of a micro-fluidic valve.
Figures 2B and 2C schematically illustrate the functioning of a micro-fluidic valve.
Figure 3A and B schematically show an aid in the manufacture of an actuator according to the invention.
Figure 4 shows a membrane pump according to the invention.

The term "or" as used herein means "and/or" unless specified other wise.

The term "a" or "an" as used herein means "at least one" unless specified other wise.

When referring to a moiety (*e.g.* a compound) in singular, the plural is meant to be included. Thus, when referring to a specific moiety, *e.g.* "compound", this means "at least one" of that moiety, *e.g.* "at least one compound", unless specified otherwise.

The phrase "near" an extremity or surface is used herein to indicate a region closer to that extremity or surface than to an essentially opposite extremity or surface of a product or part thereof (actuator/electro-active layer) of which the region forms part. More in particular this phrase is used to indicate a region closer to that extremity or surface than to the heart of the product or part thereof (actuator/electro-active layer) of which the region forms part.

The term "electro-active" is used herein for a material which is capable of converting a non-electric form of energy into electric energy or *vice versa.* Thus an electro-active material may be capable of converting mechanical energy or electromagnetic radiation (such as UV, visible light or IR) into electrical energy or transferring electrical energy into mechanical energy or electromagnetic radiation. In particular an electro-active material is capable of acting as a (semi-) conductor for electrical energy.

At least during use, the electro-active layer is typically situated in electrical communication with the electrodes.

In particular a difference in stiffness may exist between a first and a second surface respectively a first and a second extremity of the electro-active layer. Thus, in particular a stiffness gradient may exist between such first and second surface or extremity. Such gradient may be essentially gradual (e.g. an essential linear increase or decrease from a first to a second surface or extremity) or stepwise. The presence of a gradient in stiffness enhances the actuator performance and makes the need for a frame or part thereof obsolete.

The invention further relates to the use of an actuator for converting between mechanical and electrical energy, comprising at least a first and a second electrode and an electro-active layer, the layer comprising an electro-active polymer or electro-active polymer composition positioned between the two electrodes and arranged to deflect from a first position to a second position in response to a change in electric field, wherein the stiffness of the actuator at or near a first surface or part thereof differs from the stiffness at or near a second surface or part thereof, essentially opposite to the first surface, or wherein the stiffness of the actuator at or near a first extremity differs from the stiffness at or near a second extremity, essentially opposite from the first extremity, as a fluid manipulator, in particular as a valve or as a pump for manipulating a fluid.

In particular an actuator (of a micro-fluidic device) according to the invention is arranged for manipulating one or more fluids, in particular for changing a flow rate (*e*.*g*. pumping/stopping), changing a flow direction, mixing, changing flow momentum, changing flow turbulence, changing fluid energy, changing a thermodynamic property, changing a rheological property or changing flow vorticity.

In particular in case the actuator may be in contact during use with a reactive fluid (such as a corrosive gas or liquid) or with a electrically conductive fluid (such as an aqueous liquid comprising as salt), it is preferred that the electrodes are protected from direct contact with the fluid. Thus, one or more of the electrodes may be provided with (covered with or encapsulated in) a barrier layer, preventing the fluid coming in contact with the electrode. In case the fluid is a electrically conductive liquid, the barrier layer prevents the leakage of an electrical current trough the liquid, which would be detrimental to the efficiency of the electro-active polymer.The barrier layer may be a polymer layer. The polymer may be an insulating polymer or an electroactive polymer, such as the electroactive polymer of the electro-active layer. Such electroactive polymer may in particular be used, for ease of processing. An effective layer thickness may be chosen for the barrier may be chosen within wide limits and may for instance be up to 30 µm, up to 50 µm, up to 100 µm or more. If present. the minimum desired thickness is dependent upon the barrier properties of the material and the desired level of protection, for instance, the thickness may be about 1 µm or more, at least 5 µm or at least 10 µm. In principle the thickness may be less than 1 µm though.

In general, the electro-active polymer (composition) is or forms part of an elastomer, in particular a dielectric elastomer. A dielectric elastomer typically is capable of displaying electro-active behaviour associated with electrostatic pressure, such as Maxwell stress (Kwang Kim et al. "Standard testing methods for extensional and bending electroactive polymer actuators", Proceedings of the IMECE 2005, November 5-11, 2005, Orlando, FL, USA).

Such behaviour should be distinguished from piezo-electric behaviour. Unlike dielectric elastomers, piezo-electric polymers, generally show a relatively low mechanical strain under the application of a voltage, typically of less than 1 % (Kwang Kim *et*. *al*).

An electro-active polymer (composition) of an actuator (in a device) according to the invention is typically mechanically deformable under influence of an electric potential, at least when provided with suitable electrodes. In particular, the electro-active polymer or electro-active polymer composition (at least when provided with suitable electrodes) or an actuator according to the invention shows a deformation (expansion, contraction) of more than 1 % (at 20 V/µm), more in particular or of at least 2 % (at 20 V/µm), at room temperature (23 °C) and a relative humidity of 50 %. Preferably, the deformation (expansion, contraction) is at least 5 % at 20 V/µm, more preferably at least 5 % at 10 V/µm, at room temperature (23 °C and a relative humidity of 50 %).

The actuator may in particular be a bending actuator, *i.e.* an actuator whose dominant motion is a bending deformation upon application of an electric field. In an alternative embodiment, the actuator is and extensional actuator, i.e. an actuator that expands or contracts upon application of an electric potential. In an alternative embodiment, the actuator is a membrane actuator, i.e. an actuator that deflects upon application of an electric potential.

In an embodiment, the actuator is both an extensional and a bending actuator.

It has surprisingly been found that an actuator can be provided wherein stiffness of the assembly of electro-active layer and electrodes, as such, stiffness at a first surface/extremity is different from the stiffness at a second surface/extremity and that such actuator is capable of demonstrating sufficient deformation - in particular also bending deformation - in order to allow manipulating a fluid, also in a micro-fluidic device.

Thus, an actuator may be operated without needing a special frame facilitating deformation and restoration to an undeformed state. This is advantageous with respect to the compactness of the actuator.

Also, it has been surprisingly found that it is possible to provide an actuator wherein the stiffness is different from a first surface/extremity to a second surface/extremity that is sufficiently thin for use in a small or thin device, such as a micro-fluidic device.

The difference in stiffness can be determined using indentation measurements. Herein a pointy object is pressed into the first surface or extremity, respectively the second surface or extremity and measuring the force required to achieve a specific deformation. From the result the change in hardness and/or stifness can be determined. This technique is described in more detail in "Boersma, A., Soloukhin, V.A., Brokken-Zijp, J.C.M., De With, G. Load and depth sensing indentation as a tool to monitor a gradient in the mechanical properties across a polymer coating: A study of physical and chemical aging effects, Journal of Polymer Science, Part B: Polymer Physics 42 (9), pp. 1628-1639. The ratio of the lower stiffness to the higher stiffness is usually less than 0.99. Preferably the ratio is 0.95 or less, in particular up to 0.90. Usually the ratio is at least 0.5.

Preferably, the difference is at least partially caused by a difference in polymerisation degree, such as a difference in the average molecular weight of the polymer at or near a first surface/extremity from the average molecular weight at or near a second surface/extremity. In particular a difference in stiffness may be the result of a difference in crosslinking degree.

It is also possible to provide a difference in stiffness, by providing one or more additives in a gradient, such that the concentration differs from one extremity or surface to another. Such additive may in particular be selected from the group of plasticizers, fillers, solvents and the like.

Thus, the difference may be realised whilst forming the electro-active lay by polymerisation, without needing an extra process step after the layer is formed to impart the difference in stiffness.

An alternative or further method to impart a difference in stiffness include providing one or more extra layers of a material having a different stiffness to the electro-active layer (adding to complexity of the manufacturing the actuator and/or leading to a thicker actuator). One or more of the extra layers can be used as an electrode for supplying an electric current to the electro-active polymer.

An alternative or further method or pre-straining the electro-active layer in a specific way (adding to complexity of the manufacturing the actuator, not suitable for *in situ* manufacture of an actuator in a device). When pre-straining the layer, the E-modulus increases, resulting in lower deformation. Furthermore, a pre-strained layer has a symmetric stiffness difference, whereas an asymmetric stiffness gradient from one surface to the other is advantageous for a deformation in accordance with the invention.

Thus, the electro-active layer in an actuator of the invention may be unstrained, if desired, and/or the actuator may be formed of a monolithic electro-layer (i.e. a single layer rather than a multilayered composite) and electrodes, without any further layers for modifying stiffness. In particular for a fluid handling application it is considered advantageous to limit the number of layers, as a fluid may penetrate into an actuator through an interface between two layers of an actuator if adherence between the layers is insufficient. Thus, each extra layer may cause an increased risk of malfunctioning of the actuator. Furthermore, extra layers require extra processing steps which makes the production of micro-fluidic devices more complex.

A method for providing an actuator comprising an electro-active layer wherein the difference in stiffness is realised as part of the polymerisation process wherein the layer is formed will now be described in more detail, below.

The actuator may be manufactured, based on techniques, which are known *per se,* with the proviso that conditions are chosen such that a difference in stiffness is achieved.

In an embodiment, the electroactive polymer (composition) is shaped into a desired form, e.g. a film, a foil, a tape, a bar, a rod or a sheet. Advantageously, the polymer (composition) is in a flowable form, such as a melt, a solution, a fluid dispersion or a liquid mixture. This allows manufacture of the actuator *in situ, i.e.* in or on a device from which it may be intended to form a part. In particular, the actuator may be formed *in situ,* in a recess of a microfluidic device.

Suitable shaping techniques include spraying, casting, moulding, spin coating, dipping, extruding, printing and rapid manufacturing (3-D modelling, rapid prototyping).

In case the polymer (composition) is flowable, it is allowed to harden after shaping (such that it retains it shape without being supported), in particular it is allowed to solidify.

Accordingly, the present invention also provides a method for preparing an actuator as defined above, in particular in or on a fluid handling device, more in particular a microfluidic device, comprising
- providing a fluid mixture for preparing the electro-active layer, the mixture comprising the electro-active polymer (composition), or at least one component selected from the group of prepolymers and monomers for forming the polymer, optionally one or more other ingredients, such as at least one ingredient selected from the group of plasticizers, polymerisation initiators, fillers and electro-activity enhancing agents;
- shaping the fluid mixture; and thereafter
- allowing the mixture to solidify, thereby forming the electro-active layer.

The term "prepolymer" is used herein for a polymer comprising one or more polymerisable groups, such as vinyl (*e.g.,* acrylic or styrenic), epoxy, isocyanate, or acetylene groups.

In a preferred embodiment, the fluid mixture is allowed to solidify by controlling polymerisation in the shaped mixture such that the development of the polymerisation process at or near a first surface or extremity is different from the development at or near a second surface or extremity, such that a different stiffness is achieved. Such a difference can be achieved in various ways.

Suitable is a method wherein a polymerisable compound in the fluid mixture is allowed to (further) polymerise upon activation (such as by curing under influence of radiation, heat or addition of a specific chemical), wherein the mixture is allowed to cure (*e*.*g*. by crosslinking) by exposing a first surface or extremity to a different form of activation (qualitatively or quantitatively) than the second surface or extremity or wherein the activation is performed at only on surface or extremity.

Particularly suitable is a method wherein a polymerisable compound in the fluid mixture is allowed to (further) polymerise upon activation by radiation (such as by photo-curing), and wherein the mixture - preferably comprising a photo-initiator - is allowed to solidify by exposing a first surface or extremity to a different amount of activation energy than the second surface or extremity.

This can for instance suitably be accomplished by exposing said surfaces/extremities to electromagnetic radiation of a different intensity, to expose the surfaces/extremities for a different period of time or to expose only a first or only a second surface/extremity at a suitable exposure time and with a suitable intensity.

If exposure time and/or intensity are too long, the stiffness may be homogeneous throughout the layer. Suitable times and intensities depend on the desired gradient, thickness of the material, transparency of the material, characteristics of the prepolymer or monomer, the presence of additives such as a photo-initiators, etc. The skilled person can routinely determine a suitable exposure time and intensity, based upon common general knowledge, the information disclosed herein and optionally performing some routine testing.

When irradiating a layer from one side, the intensity of the radiation decreases from one surface of the layer to the other, while penetrating in this layer, leaving a layer having a gradient in curing parameters, and thus a gradient in properties. A limited time or intensity of curing results in a larger gradient in stiffness, whereas a longer intensity or time result in a full curing of the layer and a homogeneous material. A stiffness gradient can also be obtained by irradiation of the pre-polymer through another material, such as a polymer (e.g. polyethylene, polypropylene, waxes, etc.) or a glass.

Further, thermal hardening may be used to accomplish a difference in stiffness. For instance, in an embodiment the fluid mixture is allowed to (further) polymerise upon thermal activation, wherein the mixture - preferably comprising a thermo-initiator - is allowed to solidify by keeping a first surface or extremity at a different temperature than the second surface or extremity.

Suitable times, temperatures, and temperature differences depend on the desired gradient, thickness of the material, transparency of the material, characteristics of the prepolymer or monomer, the presence of additives such as a thermal initiators, etc. The skilled person can routinely determine a suitable exposure time and intensity, based upon common general knowledge, the information disclosed herein and optionally performing some routine testing.

A difference in temperature may also be used to affect physical solidification. For instance by a difference in cooling rate between the surfaces/extremities difference in crystallinity may be accomplished in case the polymer is crystallisable. This may result in a difference in stiffness.

A difference in stiffness may also be accomplished by providing at least two fluid mixtures having a different composition, which mixtures are applied as different sub-layers or at essentially opposing extremities, such that after solidification the electro-active layer is provided, having a difference in stiffness between the first and second surface respectively extremity. Such a method is in particular suitable to provide a step-wise gradient in stiffness from a first surface or extremity to a second surface or extremity.

The different fluid mixtures may for instance differ in concentration and/or type of polymer, initiator, and/or one or more additives which may affect stiffness, for instance one or more plasticizers.

In an embodiment for manufacturing the actuator, the mixture is provided with a liquid plasticizer, wherein
- only a part of the electro-active layer is selectively covered to avoid or at least reduce evaporation of the liquid plasticizer via the covered part of electro-active layer relative to the uncovered part of the electro-active layer; thereafter
- at least part of the plasticizer is allowed to evaporate or leach from the uncovered part, thereby forming an electro-active polymer layer having a gradient in stiffness from the first surface or part thereof to the second surface or part thereof or from the first extremity to the second extremity.
Suitable covers are known in the art and include, e.g., sheets of metal, glass or another material which is substantially impermeable to the plasticizer.

Preferably only a first surface/extremity or only a second surface/extremity is at least partially covered.

In particular, an actuator in accordance with the invention may have any desired shape.

The invention is in a particular embodiment advantageous in that it allows the provision of a thin actuator. In particular, the actuator may have a thickness (referring to its size in the smallest dimension) of less than 1000 µm, in particular of 750 µm or less, more in particular of up to 500 µm, up to 300 µm, up to 200 µm or up to 100 µm. The thickness usually is at least 10 µm, in an actuator having an advantageous stiffness difference in stiffness from one extremity or surface to another. Preferably the thickness is at least 25 µm or at least 50 µm. A lower or higher thickness may be provided, for instance in a microfluidic device, depending upon the size of the recess wherein it may be provided. Thus, the actuator may in particular be foil-shaped (*e.g.* as a membrane or film), tape-shaped, bar-shaped or rod-shaped. In particular a rod-shaped or bar-shaped actuator may in particular be useful as a bending actuator, more in particular for use as a valve to manipulate a fluid. The length of a (bar-shaped or rod-shaped) actuator may in particular be at least 10 times the thickness, more in particular 10-200 times the thickness.

After shaping, usually the at least two electrodes are applied to the shaped polymer (composition) such that they are in electrically conductive contact with the polymer (composition). Suitable application techniques are known in the art and can routinely be chosen based upon the material of choice for the electrodes and include spraying, casting, moulding, spin coating, dipping, printing, rapid manufacturing (3-D modelling, rapid prototyping). It is also possible, to apply the polymer (composition) to a first electrode, and then apply the second electrode, preferably after the polymer has solidified. This is in particular suitable when manufacturing the actuator *in situ, e.g.* in a microfluidic device.

The electrodes may be made of any electrically conductive material, in particular any material suitable for use in polymeric conductive devices. Such materials are known in the art and include materials selected from the group of metals, metalloids, (semi-)conductive carbon, (semi-) conductive electrolytes electrically conductive polymers and compositions comprising at least one of electrically conductive fillers, electrically conductive greases and electrically conductive particles.

At least one of the electrodes may be a relatively stiff material, for instance it may be a metal or metalloid (including metal/metalloid alloys). In particular such electrode may be a metal electrode comprising a metal selected from aluminium, gold, silver and tin.

At least one of the electrodes may be of material having a relatively low stiffness, in particular a material comprising a component selected from graphite powder, silver filled grease, carbon nanotubes, solid electrolyte, sprayed electrolyte or injected ions.

The electrodes may be of the same or a different material. In case the electrodes are of a different material with a different stiffness, this difference may contribute to the deflection properties of the actuator.

However, by providing an electro-active layer wherein stiffness at or near a first surface or extremity is different from the stiffness at a second surface, the electrodes do not need to contribute to such difference. Thus, the thickness of the electrodes does not need to be high enough to impart a difference in stiffness.

The electro-active layer may in particular comprise a dielectric elastomer.

Preferred electroactive polymers include polymers, comprising aromatic moieties in the chain and flexible moieties in the chain, the polymer further comprising side groups bound to the chain, which side groups are selected from the group consisting of polar side groups and side groups comprising an aromatic moiety. Such polymers are disclosed in the yet to be published application PCT 2007/050138.

The flexible moiety in the electroactive polymer is in particular a moiety that contributes to a low glass transition temperature (Tg) of the polymer. More in particular, a moiety is considered flexible when it imparts a Tg of 0 °C or less, preferably of -20°C. The Tg may be as low as -100 °C or even lower. Accordingly, the polymer (or a composition comprising the polymer) preferably has a Tg of 0 °C or less, preferably of -20°C or less, more preferably of-100 to -20 °C. The Tg as used herein is the Tg as determinable by the first run in a differential scanning calorimetry (DSC) measurement at a heating rate of 10 °C/min (10 mg sample, nitrogen atmosphere).

The skilled person will be able to select suitable moieties based on common general knowledge and the information disclosed herein. Preferred flexible moieties include (cyclo) aliphatic ether moieties, (cyclo) aliphatic ester moieties, (cyclo) aliphatic thioether moieties and (cyclo) aliphatic thioester moieties. A suitable flexible moiety is represented by the general formula -Rₓ-Fl-R_{y}- wherein Fl represents an ether, ester, thioether or thioester link and Rₓ and R_{y} represent the same or different linear or branched alkylene or cycloalkylene, preferably a C1-C6 alkylene or a C5-C6 cycloalkylene.

The aromatic moieties in the chain and/or in the side groups preferably have 6-20 carbon atoms. The aromatic moieties typically comprise one or more aromatic rings. Particularly suitable are optionally substituted phenyl groups, optionally substituted anthracene groups and optionally substituted naphthalene groups. An aromatic moiety comprising a phenyl group is particularly preferred.

Preferred polar moieties as (part of) the side groups include moieties selected from the group consisting of-OH, -CN, -NH₂ , -NO₂ , aryloxy (such as -phenoxy), -phenyl, halogens (such as -Cl, -F, -I, -Br), -(CO)(NH₂)-, -COOH, -(CO)(NHR)-, -(CO)(NRR)- NHR and NRR. In these moieties each R independently represents an alkyl which may be substituted or unsubstituted, in particular a substituted or unsubstituted C1-C6 alkyl.

A preferred polymer (in an actuator) of the invention comprises both side groups with aromatic moieties and side groups with polar moieties, side groups with both aromatic moieties and polar moieties, or a combination thereof.

Good results have been achieved with a polyurethane-(alkyl)acrylate copolymer according to the invention (comprising said moieties in the chain and said side groups. Preferably at least part of (alkyl)acrylate units are based on a monomer represented by formula I and/or formula II 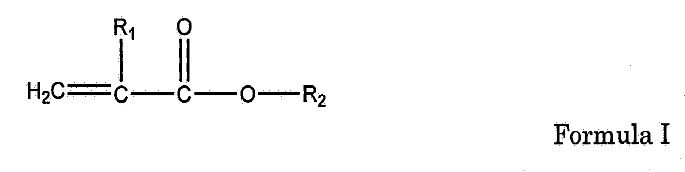 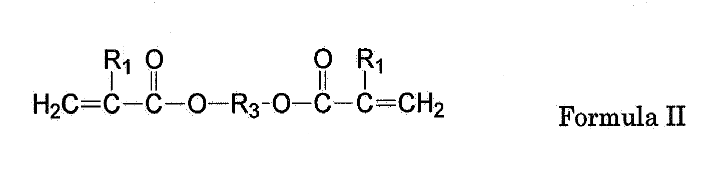 wherein each R₁ is independently hydrogen, an optionally substituted alkyl (in particular methyl) or a polar moiety
wherein R₂ is a polar moiety, an aromatic moiety (as defined above, and preferably an aromatic moiety containing a phenyl group) an optionally substituted alkyl or hydrogen
provided that at least one or R₁ and R₂ is a polar moiety or an aromatic moiety.

R₃ comprises at least one aromatic moiety based on an aromatic diisocyanate, in particular on an aromatic diisocyanate selected from the group consisting of toluenediisocyanate (TDI) and methylene diphenyl isocyanate (MDI).

Such an electro-active polymer has been found favourable in that it can be processed easily. Advantageously, such polymer may be flowable at room temperature, which makes it easy to shape it into any desired form and thickness by diverse techniques. This, is particularly advantageous with respect to manufacturing the actuator in or on a micro-fluidic device.

Preferably at least part of the aromatic moieties in the chain are based on an aromatic diisocyanate, in particular on an aromatic diisocyanate selected from the group consisting of toluenediisocyanate (TDI) and methylene diphenyl isocyanate (MDI).

The electro-active layer preferably has a dielectric constant ε, as determinable by dielectric relaxation spectroscopy at room temperature (23 °C), 50 % relative humidity (RH) and a frequency of 20 Hz of at least 10, more preferably of at least 15, even more preferably more than 20.

The upper limit is not particularly critical. In principle it may be 100 or more. For practical reasons ε may be 100 or less, more in particular 75 or less, or 50 or less.

A preferred electro-active layer has a relatively low E-modulus, as determinable by a tensile tester at room temperature (23 °C), 50% RH and a tensile speed of 5 mm/min. In particular for use in an actuator the E-modulus is preferably 20 MPa or less, more preferably 10 MPa or less. For practical reasons, the E-modulus is usually at least 0.1 MPa.

For improving mechanical stability, the polymer may be cross-linked. For improving strength and/or tear resistance the number of cross-links is preferably at least 0.0005 mol cross-links per 1000 g, more preferably at least 0.001 cross-links per 1000 g. In view of maintaining an advantageously low E-modulus, the amount of cross-links is preferably less than 0.4 mol cross-links per 1000 g, more preferably less than 0.2 mol cross-links per 1000 g. As indicated above, crosslinking is advantageously carried out such that the polymer at or near a first surface or extremity has a different crosslinking density that the polymer at or near a first surface or extremity.

The polymer (used) according to the invention preferably has a weight average molecular weight (Mw) of at least 5 000 g/mol. For improved strength (such as resistance against tearing) Mw is preferably at least 20 000 g/mol. For favourable deformation properties, Mw is preferably 200 000 g/mol or less, in particular 150 000 g/mol or less. The Mw as used herein is the Mw, as determinable by GPC using polystyrene standards, of the polymer in an non-cross-linked state. A difference in stiffness may be accomplished by applying polymers having a different average molecular weight in at least two sub-layers or by applying different polymers from a first extremity to a second extremity. (*e.g.* by printing, spraying, rapid manufacturing or the like). Preferably such sub-layers are provided in liquid form and curing (crosslinking, further polymerisation or other form of solidification) is carried out thereafter to form the electro-active layer. Thus an essentially monolithic layer structure can be obtained.

The polymer may be used as such or form part of a polymer composition. Such composition comprises a polymer of the invention and one or more other components. The electroactive polymer concentration is preferably at least 50 wt.%, more preferably at least 60 wt. %. The upper limit is not particularly critical and may be 99 wt. % of the composition or more.

In particular one or more components may be present such as one or more components selected from other polymers, additives having an ε-increasing effect, etc. In particular when the composition is to be used in an actuator, the additives are usually chosen in an amount such that the E modulus is less than 20 MPa, preferably 0.1-10 MPa and/or ε is at least 10, preferably more than 15, in particular 25-100.

Preferred additives include carbon nanotubes having a high ε, (ceramic) particles having a high ε and organic polarisable compounds having a high s (in particular having a higher ε than the polymer, more in particular an ε of at least 50). Examples of such particles include BaTiO₃, lead zirconate titanate (PZT) and other ferroelectric ceramic particles. Examples of polarisable compounds include aromatic conjugated organic molecules, such as phtalocyanine derivatives.

Such other components may be used in an amount in the range of 0.1 to 40 wt.%.

In an advantageous embodiment, the polymer composition (used) according to the invention comprises at least one (organic polarisable) compound represented by the formula P₁-Ar₁-X-Ar₂-P₂
wherein
P₁ and P₂ are the same or different polar moieties, preferably selected from the group consisting of-OH, -CN, -NH₂, NHR, NRR, -NO₂ , aryloxy , -phenyl, halogens, -(CO)(NH₂)-, -(CO)(NHR) -(CO)(NRR) and -COOH, wherein each R is the same or a different C1-C6 substituted or unsubstituted alkyl group, and more preferably at least one of P₁ and P₂ is selected from -NH₂ and -NO₂, -NHR, -NRR, a hydroxyl, a cyanide and a carbonyl group;
Ar₁ and Ar₂ are aromatic moieties, preferably as defined above, more preferably a moiety comprising an (optionally substituted) aromatic C-6 ring; and X represents a moiety comprising a double bound, preferably a C=C or N=N bond.

Particularly suitable examples of polarisable compounds include Disperse Red 1 and Disperse Orange 3.

Such a compound may be used in a polymer to improve its electroactive properties, in particular it may be used to increase ε.

Such compound may be present in a concentration of 0.1 to 30 wt.% of the total composition.

The polymer (used) in accordance with the invention may be prepared based upon any method known in the art.

In an embodiment a polymer (used) according to the invention is prepared by polymerising a mixture containing (a) at least one monomer comprising at least one polar side group and/or at least one aromatic side group (such as the (alkyl)acrylate) and (b) at least one component selected from monomers and prepolymers providing the aromatic moiety in the chain of the polymer which is prepared (such as isocyanate monomers and urethane-(alkyl)acrylate prepolymers, wherein the prepolymer optionally comprises one or more (alkyl)acrylate units which comprise at least one polar side group). A prepolymer is a polymer containing one or more functional groups, such that it can be further polymerised. The prepolymer may for instance be polymerised aided by UV light and/or thermal energy.

Advantageously in the preparation of the polymer, the mixture comprises (a) 15-90 wt. % of the monomer comprising at least one polar side group and/or at least one aromatic side group (based on the total weight of the used ingredients to prepare the polymer from) and (b) 5-75 wt. % of the component selected from monomers and prepolymers providing the aromatic moiety in the chain of the polymer which is prepared. Suitable compositions are disclosed in the yet to be published European application no. 06075808.3

In an embodiment, an electro-active layer is provided by a polymer composition comprising a suitable plasticizer to impart or increase electro-activity. Suitable compositions are disclosed in the yet to be published European application no. 06076435.4. Preferably both plasticizer and polymer are polar compounds.

The plasticizer preferably is a liquid at 20 °C.

The plasticizer preferably has a dielectric constant (ε) of at least 20, in particular of 25-100.

A preferred plasticizer in such a composition is a compound represented by the formula Yₙ-Ar-Xₘ, wherein
- each Y independently represents a polar moiety;
- Ar represents an aromatic moiety;
- each X independently represents a moiety comprising an ester, ether, thioester or thioether link
n is the number of moieties Y bound to Ar and is an integer of at least 1; and
m is the number of moieties X bound to Ar and is an integer of at least 1. Moiety Y may in particular be selected from the group consisting of -OH, -CN, -NH₂, -NO₂, aryloxy , -phenyl, halogens, -COOH, NHR, NRR, -(CO)(NH₂)-, -(CO)(NHR) and -(CO)(NRR), wherein each R represents the same or a different substituted or unsubstituted hydrocarbon group, and preferably at least one moiety Y is selected from the group consisting of -NO₂, -F, -Cl, -Br, -I and -CN.

The polymer in such composition may in particular be selected from polyvinyl chlorides, polysaccharides, aromatic urethanes, aromatic urethane acrylates, (alkyl)acrylates, acrylonitrile polymers, polysaccharide derivatives (such as starch acetate, cellulose (tri)acetate), polyethers, polyvinylpyrrolidone, polyethyloxazoline, polyvinylidene fluoride, and polymers (as described above) comprising aromatic moieties in the chain and flexible moieties in the chain, the polymer further comprising side groups bound to the chain, which side groups are selected from the group consisting of polar side groups and side groups comprising an aromatic moieties, including copolymers of any of these polymers.

A difference in stiffness may for instance be accomplished in a similar manner as described above. It is also possible to provide an electro-active layer by applying at least two polymer compositions in different sub-layers or by providing different compositions from a first extremity to a second extremity (*e*.*g*. by printing, extruding, rapid manufacturing), wherein the compositions comprise a different plasticizer or a plasticizer in a different concentration or an evaporating plasticizer, such that in the final layer a difference is accomplished.

The actuator in a micro-fluidic device of the invention may be connected with a electrical power source by metallization of the micro-fluidic device itself by means of MID (moulded interconnected devices)or by electrochemical metallization. It is also possible to provide the electric connection by using thin metallic films or strips.

The invention will now be illustrated by the following examples.

### Example 1

A polymer film was made from a composition of 2 parts by weight of a prepolymer (Actilane 170, aromatic urethane diacrylate, supplied by AKZO Nobel), 1 part by weight of an aromatic monomer (Actilane 410, phenoxyethyl acrylate, supplied by AKZO Nobel) and 3 parts by weight of a polar monomer (β-cyanoethyl acrylate, supplied by ABCR).

1 wt% photo-initiator (Irgacure 2020, supplied by Ciba) was added to the composition. The resultant mixture was applied to a glass sheet to provide a 100 µm thick film. One surface of the film was exposed in a Dr. Hönle UVA cube to UV light for 20 seconds using an F-lamp and a Qz filter.

The 100 µm thick polymer film was removed from the glass and both the upper surface and the lower surface were provided with a symmetrical graphite electrode by the deposition of graphite powder on the surfaces of the polymer. The resulting electrodes had a thickness of approx. 30 µm. The film was cut to form tapes of 15 mm (length) x 500 µm (width).

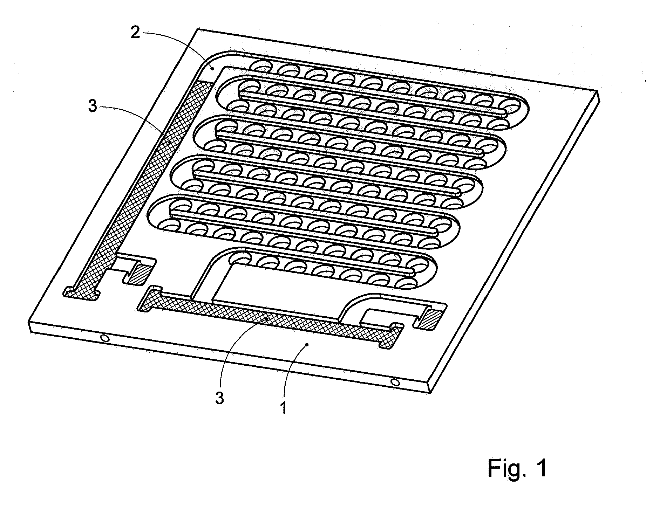

Upon activation with 1-6 kV, the tapes bended upward. Thus, the tapes functioned as an actuator. Two actuators 3 were inserted in flow channels 2 of a micro-fluidic device 1, as shown in Figure 1, and connected to an external power source, capable of generating 1-6 kV (not shown). Upon activation, the actuators bended upwards and closed the flow channel in the device. Thus, the actuators functioned as valves.

### Example 2

A polymer film, made as described in Example 1 was provided with a graphite electrode on one surface and a metallic film of 10 µm thick (tin or aluminum) on the opposite surface. The upper metallic electrode was insulated from the environment by a layer of electro-active polymer of 30 µm thickness, thus preventing the liquid coming in contact with the electrode.

The upwards bending of the polymer actuator was less than for the actuator of Example 1, but the forces that it could produce were larger.

### Example 3:

A thin film (approx. 150 µm in thickness) of prepolymer/monomer mixture as described in Example 1 was applied to a release paper.

An 8mm diameter polycarbonate ring was filled with wax and placed on top of the polymer film, after which the polymer was cured for 20 seconds in a Dr. Hönle UVA cube (F-lamp, Qz filter), by selectively exposing one surface of the film.

The wax was removed from the ring yielding a membrane of homogeneous thickness fixed to the ring. The top and bottom surface of the membrane were covered with a graphite electrode (approx 30 µm) and connected to a power source. Upon activation, the membrane expanded upwards. The stiffness gradient in the membrane caused the expansion to proceed against gravity. Alternative electrodes may be used, such as silver filled grease.

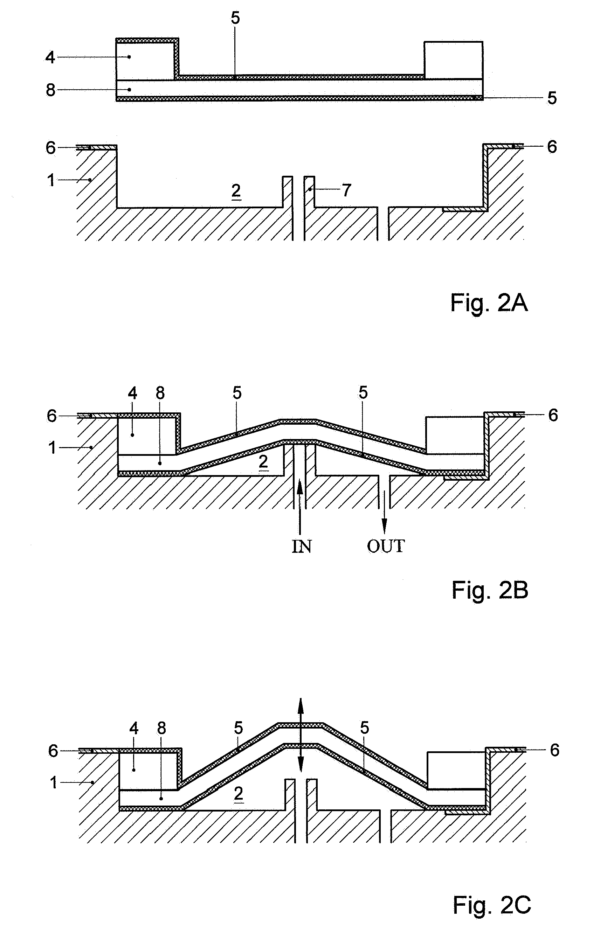

The membrane 8 was inserted in a micro-fluidic device (a valve) 1 as shown in Figures 2A and 2B. The polycarbonate (PC) ring 4 fits exactly in the recess 2 of the micro-fluidic device 1, thus requiring no adhesive or glue to prevent leakage. The nozzle 7 for the liquid to flow into the recess 2 ensures a slight pre-stretching of the membrane 8. This pre-stretching enhances the performance of the actuator. Expansion of the polymer membrane 8 results in the opening of the nozzle 7 and a flow of the liquid.

The electric connection to the external voltage source was done by the metallization of the micro-fluidic device itself by means of MID.

### Example 4

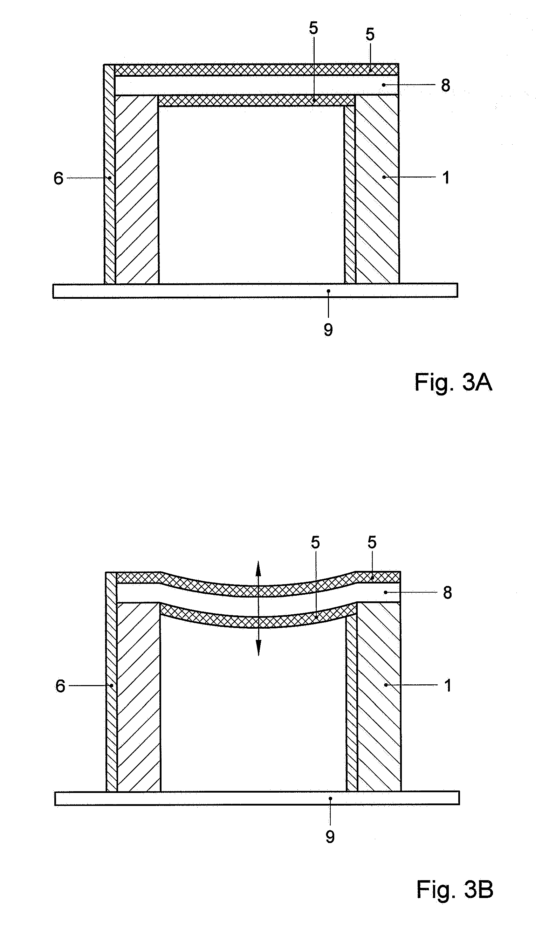

A 120 µm membrane made of plasticized PVC using 50 wt% 2-fluoro-2-nitro diphenylether as a plasticizer was adhered to a polymer ring. The PVC membrane was covered with a 20 µm graphite electrode on both surfaces and connected to a voltage source. The ring was sealed at the other side by a polymer sheet 9, thus preventing the loss of the plasticizer due to evaporation from one surface of the membrane. The plasticizer was free to evaporate from the other surface. This asymmetric evaporation resulted in a stiffness gradient over the membrane. Upon activation, the membrane deformed downwards as shown in Figure 3.

### Example 5

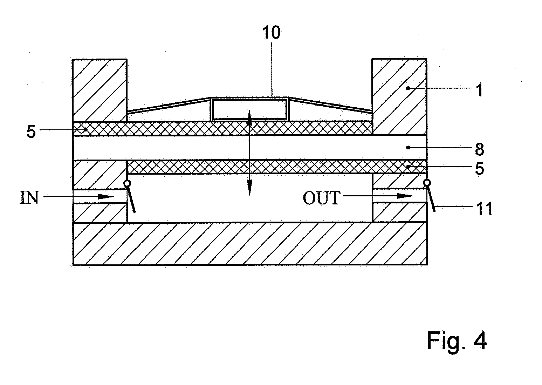

A membrane made of a polymer as described in Example 3 was adhered to the lower compartment of a rapid manufactured pump housing (Figure 4),

The polymer membrane was fixed in the spherical cavity of the housing. Both sides of the membrane were covered with a flexible electrode, such as an electrode made from graphite powder. The membrane was pushed down and stretched by means of a plastic spring 10. Upon activation, the spring pushed the membrane down and forced the liquid or gas through the in and exit channels. The exit channel is optionally provided with a movable cover 11, such as a rubber film. The stroke of the membrane depends upon the stiffness of the spring and the stiffness gradient in the membrane. The spring was manufactured form the same polymer material as the pump house. A stroke of 2-3 mm was realised when activated with an electric field of about 30 V/µm.

The spring is optional, if a spring is used the force the membrane can exercise is larger than when no spring is used. The spring enhances the movement of the membrane.

It will be understood that other materials may be used for devices shown in the Figures and that the devices shown in the Figures may have other geometries and/or properties than described in this Example.

## Claims

1. Microfluidic device comprising an actuator for converting between mechanical and electrical energy, comprising at least a first and a second electrode and an electro-active layer, the layer comprising an electro-active polymer or electro-active polymer composition positioned between the two electrodes and arranged to deflect from a first position to a second position in response to a change in electric field, wherein the stiffness of the actuator at or near a first surface or part thereof differs from the stiffness at or near a second surface or part thereof, essentially opposite to the first surface, or wherein the stiffness of the actuator at or near a first extremity differs from the stiffness at or near a second extremity, essentially opposite from the first extremity.

2. Microfluidic device comprising an actuator according to claim 1, wherein the electro-active layer of the actuator has a gradient in stiffness from the first surface to the second surface or from the first extremity to the second extremity.

3. Microfluidic device according to claim 1 or 2, wherein the first and the second electrode are of the same material, in particular a material selected from the group of metals, metalloids, (semi-)conductive carbon and (semi-) conductive electrolytes.

4. Microfluidic device according to claim 1 or 2, wherein the electrode nearer to the position in which the actuator is conceived to deflect, comprises a material having a high stiffness, in particular a metal, more in particular a metal comprising at least one component selected from the group of aluminium, gold, silver and tin, and the electrode more remote from said position comprises a material having a low stiffness, in particular graphite powder, silver filled grease, carbon nanotubes, solid electrolyte, sprayed electrolyte or injected ions.

5. Microfluidic device according to any of the claims 1-3, wherein the actuator is foil-shaped, bar-shaped or rod-shaped.

6. Microfluidic device according to any of the preceding claims, wherein the electro-active polymer is a dielectric elastomer.

7. Microfluidic device according to any of the preceding claims, wherein the electro-active polymer or electro-active polymer composition comprises aromatic moieties in the chain and flexible moieties in the chain, the polymer further comprising side groups bound to the chain, which side groups are selected from the group consisting of polar side groups and side groups comprising an aromatic moiety.

8. Microfluidic device according to claim 7, wherein
the flexible moieties of the polymer are selected from the group of (cyclo)aliphatic ether moieties, (cyclo)aliphatic ester moieties, (cyclo)aliphatic thioether moieties and (cyclo)aliphatic thioester moieties;
the aromatic moieties in the chain and - when present - in the side groups are selected from unsubstituted and substituted aromatic moieties having 6-20 carbon atoms; and/or
the side groups comprise a moiety selected from the group consisting of -OH, -CN, -NH₂, -NO₂ , aryloxy , phenyl, halogens, -COOH, NHR, NRR, -(CO)(NH₂), -(CO)(NHR) and -(CO)(NRR), wherein each R is the same or a different C1-C6 substituted or unsubstituted alkyl group.

9. Microfluidic device according to claim 8, wherein the polymer is a polyurethane-(meth)acrylate copolymer comprising aromatic urethane units and (alkyl)acrylate units, wherein preferably
at least part of (alkyl)acrylate units are based on a monomer represented by formula I 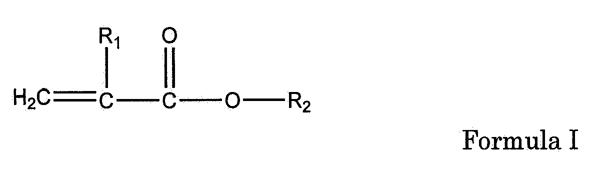 wherein
R₁ is hydrogen, an optionally substituted alkyl (in particular methyl) or a polar moiety;
R₂ is a polar moiety, an aromatic moiety (in particular a moiety comprising a phenyl), an optionally substituted alkyl or hydrogen;
provided that at least one or R₁ and R₂ is a polar moiety or an aromatic moiety; and/or wherein preferably at least part of the aromatic moieties in the chain are selected from the group of toluenediisocyanates and methylene diphenyl isocyanate.

10. Microfluidic device according to any of the preceding claims, wherein the electro-active polymer composition comprises at least one of an alkylene carbonate and a compound represented by the formula Yₙ-Ar-Xₘ, wherein
- each Y independently represents a polar moiety;
- Ar represents an aromatic moiety;
- each X independently represents a moiety comprising an ester, ether, thioester or thioether link
n is the number of moieties Y bound to Ar and is an integer of at least 1; and
m is the number of moieties X bound to Ar and is an integer of at least 1, wherein preferably Y is selected from the group of -OH, -CN, -NH₂, -NO₂, aryloxy , -phenyl, halogens, -COOH, NHR, NRR, -(CO)(NH₂)-, -(CO)(NHR) and -(CO)(NRR), wherein each R represents the same or a different substituted or unsubstituted hydrocarbon group.

11. Microfluidic device according to claim 10, comprising at least one polymer selected from the group of polyvinyl chlorides, polysaccharides, aromatic urethanes, aromatic urethane acrylates, (alkyl)acrylates, (alkyl)methacrylates, acrylonitrile polymers, polysaccharide derivatives (such as starch acetate, cellulose (tri)acetate), polyethers, polyvinylpyrrolidone, polyethyloxazoline and polyvinylidene fluoride.

12. Microfluidic device, wherein the actuator is arranged for manipulating one or more fluids, in particular for changing a flow rate, changing a flow direction, mixing, changing flow momentum, changing flow turbulence, changing fluid energy, changing flow vorticity, changing a thermodynamic property or changing a rheological property.

13. Actuator as defined in any of the claims 1-12.

14. Method for manufacturing an actuator according to claim 13, comprising
- providing a fluid mixture for preparing the electro-active layer, the mixture comprising the polymer, or at least one component selected from the group of prepolymers and monomers for forming the polymer, optionally one or more other ingredients, such as at least one ingredient selected from the group of plasticizers, polymerisation initiators, fillers and electro-activity enhancing agents;
- shaping the fluid mixture; and thereafter
- allowing the mixture to solidify, thereby forming the electro-active layer.

15. Method according to claim 14, wherein the solidification conditions are selected such that at or near a first surface or extremity of the fluid mixture a layer is formed of which the stiffness at or near a first surface respectively extremity is different from the stiffness at or near a second surface respectively extremity.

16. Method according to claim 15, wherein the fluid mixture comprises at least component selected from the group of prepolymers and monomers for forming the polymer, and the fluid mixture is allowed to solidify by controlling polymerisation in the shaped mixture such that the polymerisation process at or near a first surface or extremity is different from at or near a second surface or extremity, whereby the different stiffness is achieved.

17. Method according to claim 16, the mixture further preferably comprising a photo-initiator, wherein the mixture is allowed to solidify by selectively exposing only a part of the surfaces or extremities, preferably only one surface respectively extremity or part thereof, with electromagnetic radiation to cause polymerisation, thereby forming an electro-active polymer layer having a gradient in stiffness from a first surface or extremity to a second surface or extremity.

18. Method according to claim 16 or 17, the mixture being provided with a liquid plasticizer, wherein
- only a part of the electro-active layer is selectively covered to avoid or at least reduce evaporation via the covered part of electro-active layer relative to the uncovered part of the electro-active layer;
- allowing at least part of the plasticizer to evaporate from the uncovered part, thereby forming an electro-active polymer layer having a gradient in stiffness from the first surface or part thereof to the second surface or part thereof or from the first extremity to the second extremity.

19. Method according to any of the claims 14-18, comprising providing the fluid mixture on the first electrode and providing the second electrode on the electro-active layer.

20. Method according to any of the claims 14-19, wherein the actuator is manufactured in or on device for handling a fluid, in particular in or on a microfluidic device.

21. Method according to any of the claims 14-20, wherein electrical connections are introduced into the actuator.

22. Use of an actuator according to claim 13 or obtainable by a method according to any of the claims 14-21, for manipulating a fluid, in particular as a valve or as a pump for manipulating a fluid.

23. Membrane pump, comprising a deformable membrane for displacing a fluid, wherein the membrane is a membrane according to claim 13.
